# EUROPÄISCHE PATENTSCHRIFT

(11) **EP 0 660 986 B1**
(45) Veröffentlichungstag und Bekanntmachung des Hinweises auf die Patenterteilung: **14.05.1997**
(21) Anmeldenummer: 93921820.2
(22) Anmeldetag: 12.10.1993
(51) Int. Cl.: H04M 1/72, H03K 5/08

(54) **SCHNURLOS-TELEKOMMUNIKATIONSGERÄT**
CORDLESS TELECOMMUNICATION APPARATUS
APPAREIL DE TELECOMMUNICATION SANS FIL

(30) Priorität: 30.10.1992 DE 4236774
(43) Veröffentlichungstag der Anmeldung: 05.07.1995
(73) Patentinhaber: SIEMENS AKTIENGESELLSCHAFT, 80333 München (DE)
(72) Erfinder: LEPPING, Jürgen, D-45359 Essen (DE)
(86) Internationale Anmeldenummer: DE9300971
(87) Internationale Veröffentlichungsnummer: WO9410783

(56) Entgegenhaltungen:
- EP-A- 0 063 443
- EP-A- 0 124 166
- EP-A- 0 133 067
- GB-A- 2 238 922
- RESEARCH DISCLOSURE Nr. 309 , Januar 1990 , NEW YORK (US) Seite 18 NOMEN NESCIO 'On chip clock receiver circuit.'
- PATENT ABSTRACTS OF JAPAN vol. 12, no. 232 (E-628)(3079) 30. Juni 1988 & JP,A,63 023 413 (NEC CORP) 30. Januar 1988

## Beschreibung

Die Erfindung bezieht sich auf ein Schnurlos-Telekommunikationsgerät gemäß dem Oberbegriff des Patentanspruches 1.

Kommunikationssysteme mit Schnurlos-Telekommunikationsgeräten zur schnurlosen Übertragung von Sprach- und Nichtsprachinformationen sind in ihrer technischen Entwicklung, analog zu dem in der leitungsgebundenen Kommunikationstechnik bereits seit längerem bestehenden ISDN-Standard (Integrated Services Digital Network), an verschiedenen Standards gebunden. Neben einigen nationalen Standards und mehreren länderübergreifenden Standards, wie den CT1, CT1+ Standard auf analoger Basis und den CT2, CT3 Standard auf digitaler Basis, ist auf europäischer Ebene, analog zu dem globalen GSM-Standard (Groupe Spéciale Mobile oder Globals Systems for Mobil Communication; vgl. Informatik Spektrum, Jg. 14, No. 3, 6/1991, Seiten 137 bis 152, "Der GSM-Standard - Grundlade für digitale europäische Mobilfunknetze" v. A. Mann) für den Mobilfunk, für die leistungsschwächere Schnurlos-Kommunikation zwischen mobilen Geräten (Portables) und einer ortsfesten Station (Basis) bei Reichweiten von einigen 100 m ein Standard, der sogenannte DECT-Standard (Digital European Cordless Telecommunication; vgl. European Telecommunication Standard - Final Draft -, prETS 300 175-1...9, 5/1992, ETS-Institute 06921 Sophia Antipolis, France und Philips Telecommunication Review, Vol. 49, No. 3, 9/1991, Seiten 68 bis 73, "DECT, a universal cordless access system" v. R.J. Mulder) geschaffen worden. Ein wesentliches Leistungsmerkmal des DECT-Standards ist es, daß die ortsfeste Station an leitungsgebundene Kommunikationsnetze (z. B. PSTN = Public Switched Telephone Network; PTN = Privat Telecommunication Network) anschließbar ist.

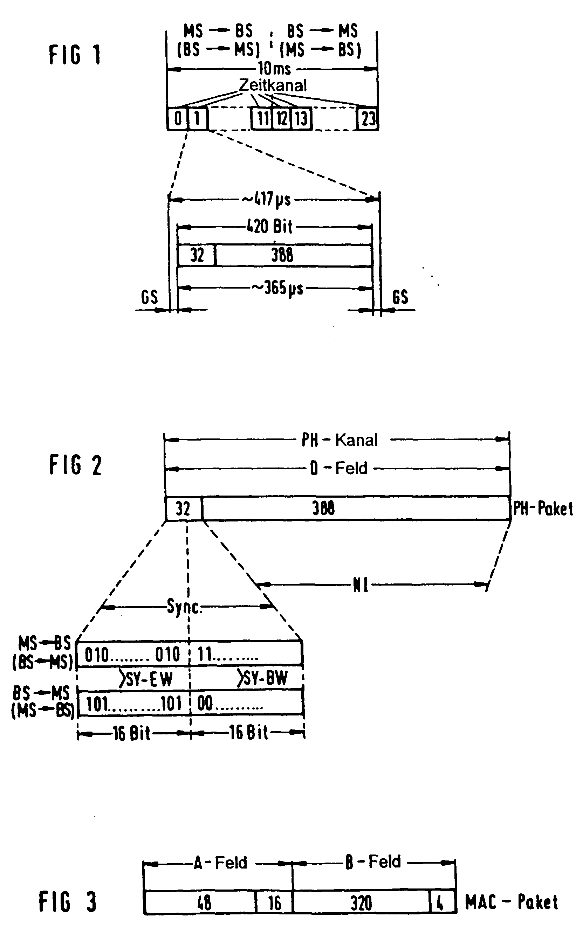

Für die schnurlose Kommunikation nach dem DECT-Standard wird eine dynamische Kanalauswahl von ca. 120 verfügbaren Kanälen durchgeführt. Die 120 Kanäle ergeben sich daraus, daß bei dem DECT-Standard zehn Frequenzbänder zwischen 1,8 und 1,9 GHz verwendet werden, wobei in jedem Frequenzband gemäß der Darstellung in Figur 1 im Zeitmultiplex (TDMA = Time Division Multiple Access) mit einem Zeitmultiplexrahmen von 10 ms gearbeitet wird. In diesem Zeitmultiplexrahmen werden 24 (von 0 bis 23) Zeitkanäle definiert und dadurch ein Rahmenschema vorgegeben. Dieses Rahmenschema wird dann derart benutzt, daß für jedes Frequenzband 12 z. B. Mobilstationen MS mit einer Basisstation BS eines DECT-Kommunikationssystems gleichzeitig im Duplexbetrieb (MS - BS und BS - MS bzw. BS - MS und MS - BS) arbeiten können. Den 24 Zeitkanälen wird dabei ein Zeitschlitz (Time Slot) von jeweils 417 µs zugeordnet.

Dieser Zeitschlitz gibt dabei die Zeit an, in der Informationen (Daten) übertragen werden. Dieses Übertragen der Informationen in Duplexbetrieb wird auch als Ping-Pong-Verfahren bezeichnet, weil zu einem bestimmten Zeitpunkt gesendet und zu einem anderen Zeitpunkt empfangen wird. Bei diesem Ping-Pong-Verfahren wird in jedem Zeitschlitz ein Zeitrahmen oder Impuls (Burst) von 365 µs, was in etwa einer Rahmenlänge von 420 Bits entspricht, mit einem Datendurchsatz von 42 kBit/s übertragen. Bezogen auf den Zeitmultiplexrahmen ergibt sich unter Berücksichtigung, daß in einem Sicherheitszeitrahmen (Guard Space = GS) an beiden Enden des Zeitrahmens jeweils 30 Bit zur Vermeidung von Überlappungen durch angrenzende Zeitschlitze zur Verfügung stehen, ein Gesamt-Datendurchsatz von 1,152 MBit/s.

Die zeitliche Aufeinanderfolge der übertragenen Impulse pro Zeitmultiplexrahmen definiert nach Figur 2 einen PH-Kanal, den sogenannten PHysical Channel, der einer physikalischen Schicht, dem sogenannten PHysical Layer (PH-L), zugeordnet ist. Das dabei übertragene Datenpaket von 420 Bits wird als PH-Paket bezeichnet und einem D-Feld zugeordnet. Von den 420 Datenbit (Folge von H/L-Bitwerten) in dem PH-Paket werden 32 Bit für die Synchronisation und 388 Bit für die Übertragung von Nutzinformationen NI (Net Information) verwendet. Die 32 Bit für die Synchronisation unterteilen sich wiederum in zwei Datenbitfolgen von jeweils 16 Bit. Die erste Datenbitfolge (Folge mit den ersten 16 H/L-Bitwerten) ist ein Sync-Einleitungswort SY-EW, mit der die Synchronisation eingeleitet wird. Für eine Übertragungsrichtung "Mobilstation MS - Basisstation BS" besteht dieses Sync-Einleitungswort SY-EW im Idealfall aus einer periodischen "101"- oder "HLH"-Sequenz und für die umgekehrte Übertragungsrichtung "Basisstation BS - Mobilstation MS" aus einer ebenfalls periodischen "010"- oder "LHL"-Sequenz. Die in Klammer gesetzten Zuordnungen sind in Abhängigkeit davon, welche Sequenz welcher Übertragungsrichtung zugeordnet wird, alternativ möglich.

Die zweite Datenbitfolge (Folge mit den zweiten 16 H/L-Bitwerten) ist ein Sync-Bestätigungswort SY-BW mit der die mit dem Sync-Einleitungswort SY-EW eingeleitete Synchronisation bestätigt werden muß. Bei dieser Bestätigung muß das Sync-Bestätigungswort SY-BW nahezu, d. h. im wesentlichen jedes Datenbit, erkannt werden. Nur wenn dies der Fall ist, wird die mit dem Sync-Einleitungswort SY-EW eingeleitete Synchronisation akzeptiert. Die Synchronisaticn ist dabei eingeleitet, wenn mit gewisser Wahrscheinlichkeit davon ausgegangen werden kann, daß das Sync-Einleitungswort SY-EW eine "HLH"- bzw. "LHL"-Sequenz ist.

Darüber hinaus sind in dem DECT-Standard analog zum ISDN-Standard mit dem ISO/OSI 7-Schichtenmodell noch weitere Schichten (Layer) definiert. Eine dieser Schichten ist ein Medium Access Control Layer (MAC-L), dem gemäß Figur 3 in einem A-Feld und in einem B-Feld die 388 Bit für die Nutzinformationsübertragung zugeordnet werden. Das A-Feld umfaßt dabei 64 Bit, die unter anderem für Meldungen (Messages) beim Zusammenschluß der Basis- und Mobilstationen des DECT-Kommunikationssystems genutzt werden. Die übrigen 324 Bits des B-Feldes, von denen 320 Bit für Sprachdaten und 4 Bit zur Erkennung von Teilinterferenzen des Impulses genutzt werden, werden weiteren ISO/OSI-Schichten zugeordnet.

Das DECT-Kommunikationssystem weist in der einfachsten Form eine Basisstation mit mindestens einer Mobilstation auf. Komplexere (z. B. vernetzte) Systeme enthalten mehrere Basisstationen mit jeweils mehreren Mobilstationen. Aufgrund der 24 im DECT-Standard definierten Zeitkanäle können der Basisstation bis zu 12 Mobilstationen zugeordnet werden, die mit der Basisstation im Duplexbetrieb kommunizieren. Für den im DECT-Standard ebenfalls definierten Zeitmultiplexrahmen von 10 ms bedeutet der Duplexbetrieb, daß alle 5 ms Informationen von der Basistation zu einer Mobilstation oder umgekehrt übertragen werden.

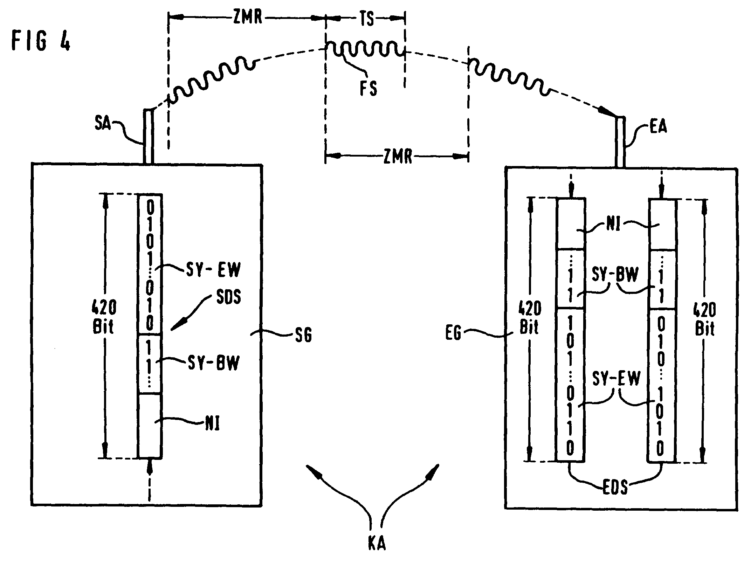

Figur 4 zeigt eine für DECT-Kommunikationssysteme typische Schnurlos-Kommunikationsanordnung KA, bei der die Mobilstation MS als Sendegerät SG und die Basisstation BS als Empfangsgerät EG dienen. Aufgrund der vorstehenden Ausführungen läßt sich die Schnurlos-Kommunikationsanordnung KA auch dahingehend modifizieren, daß die Basisstation BS als Sendegerät SG und die Mobilstation MS als Empfangsgerät EG dient. Das Sendegerät SG weist eine Sendeantenne SA auf, über die ein von dem Sendegerät SG erzeugtes Funksignal FS dem Empfangsgerät EG gesendet wird. Um das Funksignal FS empfangen zu können, weist das Empfangsgerät EG eine Empfangsantenne EA auf.

Das Funksignal FS ist gemäß der dem DECT-Kommunikationssystem zugrundeliegenden DECT-Übertragungsverbarung ein hochfrequentes Trägersignal mit einer Trägerfrequenz zwischen 1,8 und 1,9 GHz, das mit einem in dem Sendegerät SG vorliegenden digitalen Sendedatenstrom SDS mit einem sendegerätespezifischen Takt (Phase) moduliert wird. Der in dem Sendegerät SG vorliegende digitale Datenstrom enthält dabei die für die Schnurlosübertragung erforderlichen Informationen. Zu diesen Informationen gehören unter anderem die bereits erwähnten Synchronisations- und Nutzinformationen, die gemäß dem DECT-Standard z. B. in einem Informationspaket (PH-Paket) von 420 Bits enthalten sind. Mit diesem Informations- bzw. Datenpaket wird nun im Sendegerät SG das modulierte Funksignal FS (Trägersignal) erzeugt und gemäß der DECT-Übertragungsvereinbarung in regelmäßiger, durch den Zeitmultiplexrahmen ZMR vorgegebenen Zeitabständen für eine durch den Zeitschlitz vorgegebene Zeitdauer übertragen.

Um das übermittelte Informationspaket (übertragene Sprachinformation pro Zeitschlitz TS) entschlüsseln zu können, muß das Funksignal FS (modulierte Trägersignal) in dem Empfangsgerät EG demoduliert werden. Im Empfangsgerät EG entsteht nach der Demodulation ein digitaler Empfangsdatenstrom EDS, der bei einer störungsfreien Übertragung des Funksignals FS dieselbe Bitstruktur aufweist wie der Sendedatenstrom SDS (rechter Empfangsdatenstrom EDS) und der bei einer störungsbehafteten Übertragung des Funksignals eine gegenüber dem Sendedatenstrom unterschiedliche Bitstruktur aufweist (linker Empfangsdatenstrom).

Für diese Demodulation wird in bekannter Weise, bei Mobilfunkgeräten nach dem GSM-Standard, ein Analog/Digital-Konverter verwendet. Dieser Analog/Digital-Konverter tastet ein analoges Signal mit einer einstellbaren Abtastrate bitweise ab. Da diese Analog/Digital-Konverter jedoch recht teuer sind, ist man in vielen Bereichen der Schnurlos-Telekommunikationstechnik (z. B. bei der Übertragung von Sprache) an kostengünstigeren Lösungen für die Demodulation von modulierten Analogsignalen in einem Schnurlos-Telekommunikationsgerät interessiert.

Aus der GB-2 238 922 A ist ein Schnurlostelefon bekannt, das Konversionsmittel zur Umwandlung eines analogen HF-Signals in einen digitalen Datenstrom und Synchronisationsmittel zur Synchronisation des Datenstroms in bezug auf einen Gerätetakt aufweist.

Aus der EP-0 124 166 A2 ist eine Wellenform-Konverterschaltung bekannt, die aus einem frequenzmodulierten, sinusförmigen Analogsignal mit variierenden "Spitze-Spitze"-Amplitudenwerten und Gleichspannungspotentialwerten ein Rechtecksignal mit einem einheitlichen (konstanten) Impuls-Pausen-Verhältnis erzeugt. Die Konverterschaltung weist dazu einen Analog/Digital-Komparator auf, an dessen invertierenden Eingang das Analogsignal und an dessen nicht invertierenden Eingang ein aus dem Analogsignal durch Integration erzeugtes Referenzsignal anliegt. Das am Ausgang des Analog/Digital-Komparators anliegende Rechtecksignal wird über ein D-Flipflop und ausgangsseitig dazu nachgeschalteten Filtern auf die Eingänge des Analog/Digital-Komparators derart rückgekoppelt, daß bei einem sich bezüglich der Gleichspannungspotentialwerte ändernden Analogsignal das Impuls-Pausen-Verhältnis des Rechtecksignals konstant ist.

Aus der EP-0 133 067 A1 ist eine Vorrichtung zur Regeneration eines Auslesesignals von optischen Speicherdisketten bekannt, die zur Korrektur eines Auslesetaktsignales eine einem Ausleseprozessor nachgeschaltete Verformungsschaltung aufweist. Die Verformungsschaltung ist dabei als Phasenüberwachungsschleife ausgebildet, für die eine geschaltete Integratorschaltung und ein Komparator verwendet werden.

Aufgabe der Erfindung ist es, ein Schnurlos-Telekommunikationsgerät anzugeben, bei dem ein aus einem analogen Funkempfangssignal erzeugter digitaler Datenstrom unmittelbar vor und nach dem erstmaligen Auftreten von zwei gleichen aufeinanderfolgenden Bitwerten des Datenstroms in bezug auf einen Gerätetakt für gleiche Synchronisationsvoraussetzungen synchronisiert ist.

Diese Aufgabe wird ausgehend von den in dem Oberbegriff des Patentanspruches 1 definierten Schnurlos-Telekommunikationsgerät durch die in dem kennzeichnenden Teil des Patentanspruches 1 angegebenen Merkmale gelöst.

Mit den technischen Merkmalen des Erfindungsgegenstandes ist ein Schnurlos-Telekommunikationsgerät charakterisiert, in dem für den bisher bekannten Analog/Digital-Konverter zur Demodulation von modulierten Analogsignalen ein für diesen Zweck ebenfalls geeigneter, jedoch im Vergleich zu dem Analog/Digital-Konverter billigerer Datenkomparator einsetzbar ist. Der Einsatz des Datenkomparators hat darüber hinaus den Vorteil, daß nicht mehr so viele Steuerungs- und Überwachungsprozeduren in dem Schnurlos-Telekommunikationsgerät durchzuführen sind.

Vorteilhafte Weiterbildungen der Erfindung sind in den Unteransprüchen angegeben.

Ein Ausführungsbeispiel der Erfindung wird anhand der Zeichnungen mit den Figuren 5 bis 10 näher erläutert. Es zeigen:
Figur 5 anhand eines Blockschaltbildes den prinzipiellen Aufbau eines Schnurlos-Telekommunikationsgerätes mit einem Empfangs- und Digitalteil,
Figur 6 anhand eines Blockschaltbildes den prinzipiellen Aufbau des Empfangsteils in bezug auf die Demodulation eines modulierten Analogsignales,
Figur 7 eine Realisierungsform einer Integratorschaltung,
Figur 8 die Demodulation eines analogen modulierten HF-Signals (Trägersignal) mit einem Datenkomparator,
Figur 9 eine Realisierungsform für eine Kompensationsschaltung der Integratorschaltung,
Figur 10 anhand eines Blockschaltbildes den prinzipiellen Aufbau des Digitalteiles in bezug auf die Demodulation eines modulierten Analogsignales.

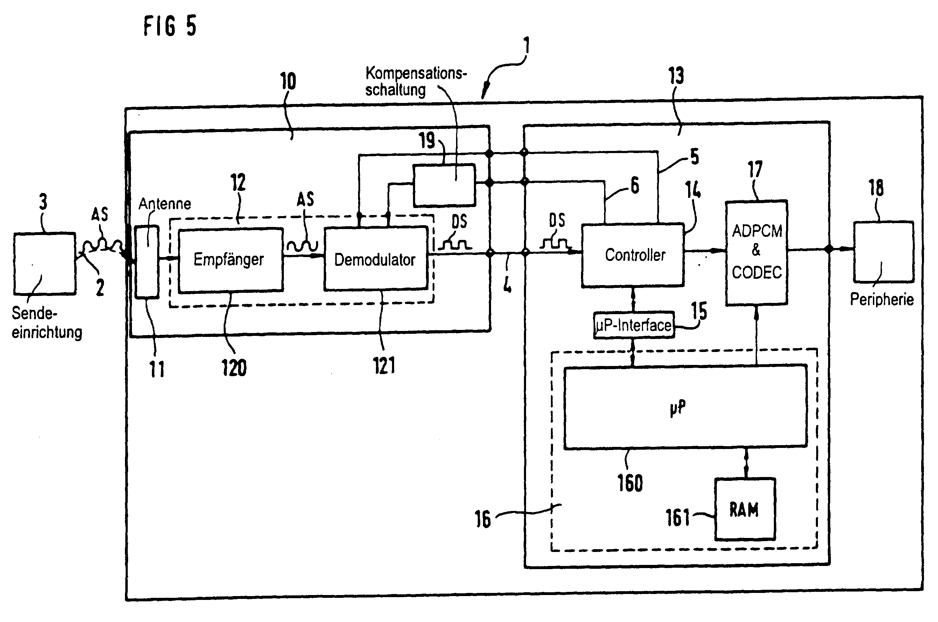

Figur 5 zeigt anhand eines Blockschaltbildes den Aufbau eines Schnurlos-Telekommunikationsgerätes 1, wie es z. B. als Basisstation oder Mobilstation in einem, insbesondere nach dem DECT-Standard definierten, Schnurlos-Kommunikationssystem verwendbar ist. Dem Schnurlos-Telekommunikationsgerät 1 sind unter anderem ein Empfangsteil 10 für den Empfang von zur Informationsübertragung modulierten analogen HF-Signalen AS, ein Digitalteil 13 zur Auswertung und Weiterverarbeitung eines aus dem jeweiligen HF-Signal AS demodulierten digitalen Datenstroms DS und ein Peripherieteil 18 zur Ausgabe bzw. Weiterleitung der mit Hilfe des HF-Signals AS und des digitalen Datenstroms DS übertragenen Informationen zugeordnet.

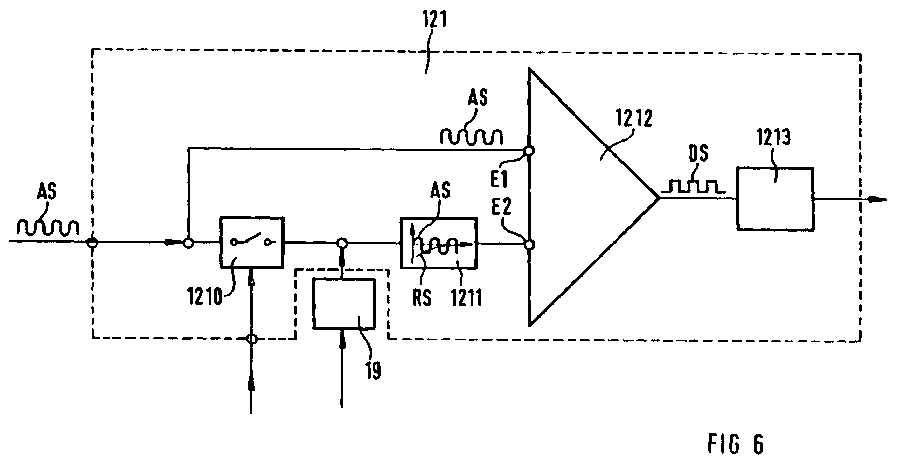

Das Empfangsteil 10 des Schnurlos-Telekommunikationsgerätes ist mit einer Antenne 110 als Funkschnittstelle über eine Funkübertragungsstrecke 2 mit einer das HF-Signal AS aussendenden Sendeeinrichtung 3 verbunden. Der Antenne 11 nachgeschaltet ist eine Empfangseinrichtung 12 mit einer Empfangsschaltung 120 (Empfänger) und einer Demodulationsschaltung 121 (Demodulator). Die Empfangsschaltung 120 ist in herkömmlicher Weise aufgebaut und bereitet das von der Antenne 11 empfangene modulierte analoge HF-Signal AS für die Demodulation in der Demodulationsschaltung 121 auf. Bei dieser Demodulation des HF-Signals AS entsteht am Ausgang der Demodulationsschaltung 121 der digitale Datenstrom DS. Wie die Demodulationsschaltung 121 aufgebaut ist und wie der digitale Datenstrom DS erzeugt wird, wird bei der Beschreibung der Figuren 6, 7, 8, 9 und 10 erläutert. Der von der Demodulationsschaltung 121 erzeugte digitale Datenstrom DS wird bei einem Datendurchsatz von bis zu 1,152 MBit/s (Mega Baud) über eine Datenleitung 4 von dem Empfangsteil 10 zu einer Steuereinrichtung 14 des Digitalteils 13 übertragen.

Diese hohe Übertragungsrate stellt insbesondere an die Steuereinrichtung 14, die sämtliche für die Auswertung und Weiterverarbeitung des digitalen Datenstroms DS in dem Digitalteil 13 erforderlichen Prozeduren und Abläufe steuert, hohe Anforderungen.

Von der Steuerung durch die Steuereinrichtung 14 betroffen ist unter anderem die Demodulationsschaltung 121, die über eine erste Steuerleitung 5 unmittelbar und über eine zweite Steuerleitung 6 mittelbar, über eine Kompensationsschaltung 19 des Empfangsteils 10, mit der Steuereinrichtung 14 verbunden ist.

Die Steuereinrichtung 14, die insbesondere mit dem Empfang des digitalen Datenstroms DS die Synchronisation des Digitalteils 13 auf dem demodulierten Datenstrom DS und die Vermittlung von Verbindungen im TDMA-Verfahren durchführt, ist ihrerseits über eine Busschnittstelle 15 einer Mikroprozessoranordnung 16 zugeordnet. Die Mikroprozessoranordnung 16 enthält einen Mikroprozessor 160 und einen digitalen Speicher 161, der mit dem Mikroprozessor 160 verbunden ist. Die Mikroprozessoranordnung 16 ist für sämtliche Steuerungs- und Programmierungsabläufe in dem Schnurlos-Telekommunikationsgerät 1 verantwortlich. So wird beispielsweise der Steuerbaustein 14 mittelbar über die Busschnittstelle 15 von der Mikroprozessoranordnung 16 programmiert.

Außerdem wird eine ADPCM- und CODEC-Schaltung 17 von der Mikroprozessoranordnung 16 gesteuert. Die ADPCM- und CODEC-Schaltung 17 übernimmt eine Schnittstellenfunktion zwischen der Steuereinrichtung 14 und dem Peripherieteil 18 des Schnurlos-Telekommunikationsgerätes 1. Für diese Schnittstellenfunktion wird die ADPCM- und CODEC-Schaltung 17 neben der Mikroprozessoranordnung 16 auch noch teilweise von der Steuereinrichtung 14 gesteuert. Unter dem Peripherieteil 18 sind insbesondere diejenigen Einrichtungen des Schnurlos-Telekommunikationsgerätes 1 subsummiert, die den von dem Digitalteil 13 bearbeiteten digitalen Datenstrom DS nach einer D/A-Umwandlung beispielsweise in akustische Signale umwandeln oder an ein externes analoges Kommunikationsnetz weitergeben.

Figur 6 zeigt den prinzipiellen Aufbau der Demodulationsschaltung 121 in bezug auf die Demodulation des am Eingang der Demodulationsschaltung 121 anliegenden HF-Signals AS. Das HF-Signal AS wird vom Eingang der Demodulationsschaltung 121 unmittelbar an einen ersten Eingang El und mittelbar, über eine Schalteinrichtung 1210 und Integrationsschaltung 1211, an einen zweiten Eingang E2 eines Datenkomparators 1212 gelegt. Der Datenkomparator 1212 wird in der Demodulationsschaltung 121 als Analog/Digital-Wandler für das am Eingang der Demodulationsschaltung 121 anliegende HF-Signal AS eingesetzt. Der Datenkomparator 1212 ist hierfür in bekannter Weise, insbesondere als integrierter Chip-Baustein aufgebaut. Um das HF-Signal AS eindeutig und fehlerfrei umwandeln zu können, benötigt der Datenkomparator 1212 eine in bezug auf das HF-Signal AS feste Bezugsgröße. Die Bezugsgröße ist häufig ein Referenzsignal RS, das in den meisten Anwendungsfällen durch Hardwaremittel erzeugt wird. Im vorliegenden Ausführungsbeispiel wird das Referenzsignal RS durch die Integratorschaltung 1211 erzeugt.

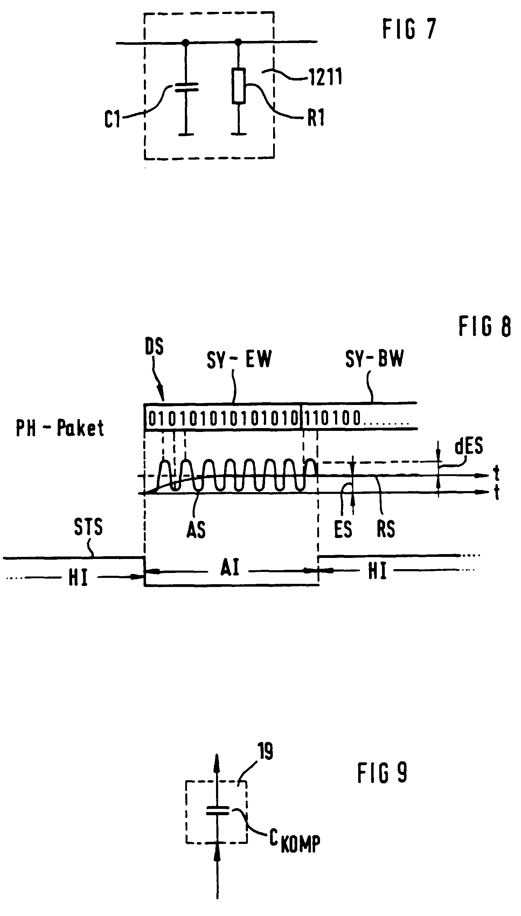

Figur 7 zeigt eine mögliche Realisierungsform der Integratorschaltung 1211, bei der eine RC-Parallelschaltung, bestehend aus einem Kondensator C1 und einem Widerstand R1, gegen Masse geschaltet ist.

Das Referenzsignal RS wird benötigt, um bei der Demodulation entscheiden zu können, ob einem Signalabschnitt des zu demodulierenden HF-Signals AS ein H-Bitwert oder ein L-Bitwert zuzuordnen ist.

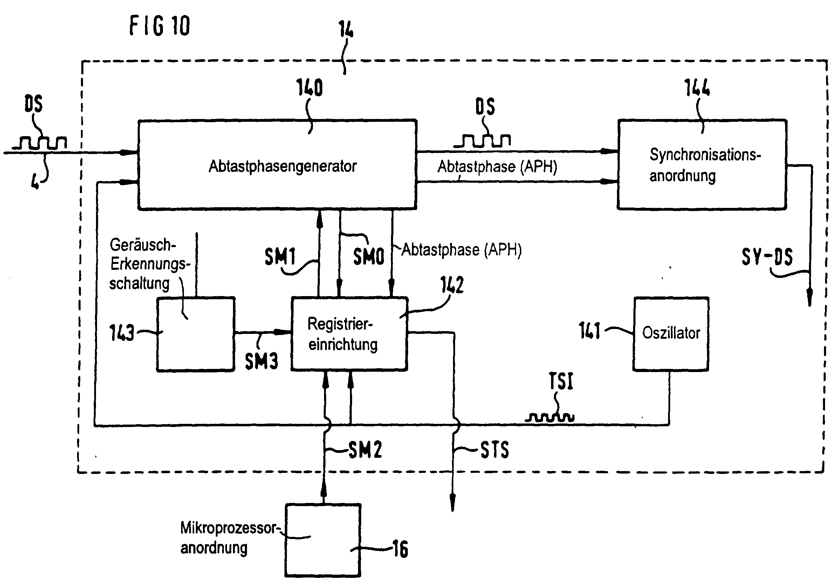

Figur 8 verdeutlicht ausgehend von den Ausführungen zu Figur 2 und 4 anhand eines ungestörten Signalverlaufes für das HF-Signal AS die geschilderte Problematik.

Das an dem Eingang El des Datenkomparators 1212 anliegende modulierte HF-Signal AS hat den dargestellten unverrauschten symmetrisch zur Zeitachse (t-Achse) verlaufenden periodischen Signalverlauf. Durch die dem Datenkomparator 1212 am Eingang E2 vorgeschaltete Integratorschaltung 1211 wird das Referenzsginal RS gebildet. Bereits nach wenigen Signalperioden des HF-Signals AS nimmt das Referenzsignal RS (Aufladeverlauf der Parallelschaltung R1, C2) seinen Maximalwert ein (eingeschwungener Zustand). Der Maximalwert definiert eine Entscheidungsschwelle ES, die für die Demodulation benötigt wird. Mit Hilfe dieser Schwelle ES erzeugt der Datenkomparator 1212 aus dem HF-Signal AS den digitalen Datenstrom DS. Den positiven Signalabschnitten des HF-Signals AS wird dabei jeweils ein H-Bitwert und den negativen Signalabschnitten jeweils ein L-Bitwert zugeordnet. Aus den ersten 16 Signalabschnitten des HF-Signals entsteht somit das Sync-Einleitungswort SY-EW. Anhand der Bitsequenz (HLH oder wie im vorliegenden Fall LHL) läßt sich gemäß Figur 2 mit den dort angegebenen Definitionen für die Übertragungsrichtungen eindeutig ermitteln, von wem das HF-Signal AS gesendet worden ist. An die Referenzsignale RS werden für die Demoulation des HF-Signals AS zwei grundsätzliche Forderungen gestellt:
(1) Die Entscheidungsschwelle ES muß innerhalb der ersten 16 Signalabschnitte des HF-Signals AS eingestellt sein,
(2) der eingestellte Wert muß während des Zeitschlitzes (Time Slot) bei der Schnurlos-Übertragung (Empfangsphase nach Figur 4) erhalten bleiben.

Aus diesen beiden Bedingungen folgt, daß neben der Demodulation des HF-Signals AS auch der Übergang von dem Sync-Einleitungswort SY-EW zu dem Sync-Bestätigungswort SY-BW erkannt werden muß. Es werden daher mit Hilfe eines durch Ansteuerung (Ein-/Aus-Schalten) der Schalteinrichtung 1210 erzeugtes Steuersignal STS ein Abtastintervall AI (Sample-Phase) und ein Halteintervall HI erzeugt. Das Abtastintervall AI erstreckt sich über die ersten 18 Signalabschnitte des HF-Signals AS. Dadurch wird sichergestellt, daß der Übergang (17. und 18. Bit des Datenstroms DS) eindeutig erkannt wird. In der DECT-Übertragungsvereinbarung ist dieser Übergang durch zwei gleiche aufeinanderfolgende Bitwerte definiert.

Mit der auf der einen Seite erforderlichen Einbeziehung dieser Bitwerte in das Abtastintervall AI verändert sich auf der anderen Seite auch das Referenzsignal RS bezüglich der Entscheidungsschwelle ES um einen Fehlerwert dES. Um die Bedingung (2) noch zu erfüllen, muß dieser Fehlerwert dES kompensiert werden. Bezogen auf die Integratorschaltung 1211 bedeutet dies, daß die Integration des HF-Signals AS durch eine Differentiation des HF-Signal AS kompensiert wird. Hierfür ist die Kompensationsschaltung 19 vorgesehen, die nach Figur 5 von der Steuereinrichtung 14 gesteuert wird. Wie diese Steuerung erfolgt, wird bei der Beschreibung der Figur 10 erläutert.

Figur 9 zeigt mögliche Realisierungsformen der Kompensationsschaltung 19. Die Kompensationsschaltung 19 weist z. B. in der einfachsten Form einen Kompensationskondensator C_{KOMP} auf.

Die Kompensation des Fehlerwertes dES mit dem in Figur 9 dargestellten Kompensationskondensator C_{KOMP} erfolgt dadurch, daß in dem Halteintervall HI des Steuersignals STS mit dem Wechsel "Abtastintervall AI zu Halteintervall HI" die in dem Kompensationskondensator C_{KOMP} gespeicherte Energie auf die RC-Parallelschaltung R1, C1 gegeben wird.

Nach der Demodulation des HF-Signals AS wird der digitale Datenstrom DS nach Figur 6 auf eine Schnittstelleneinrichtung 1213 gegeben, über die der Datenstrom DS der Steuereinrichtung 14 nach Figur 5 zugeführt wird. Die Schnittstelleneinrichtung 1213 hat unter anderem die Funktion, das Digitalteil 13 von dem Empfangsteil 10 in bezug auf den zu übertragenen Datenstrom DS zu entkoppeln.

Figur 10 zeigt in einem Blockschaltbild den prinzipiellen Aufbau des Digitalteils 13 nach Figur 5, wie er insbesondere zur Synchronisation des von dem Empfangsteil 10 empfangenen digitalen Datenstroms DS erforderlich ist. Die Steuereinrichtung 14 weist dazu einen Abtastphasengenerator 140 auf, dem zur Erzeugung einer Abtastphase APH der digitale Datenstrom DS zugeführt wird. Zur Erzeugung dieser Abtastphase ist der Abtastphasengenerator 140 mit einem Oszillator 141, einer Registriereinrichtung 142 und einer Geräusch-Erkennungsschaltung 143 verbunden.

Der Oszillator 141 erzeugt ein Taktsignal TSI, dessen Taktfrequenz ein n-Vielfaches der Übertragungsgeschwindigkeit des digitalen Datenstroms DS ist. Das Taktsignal TSI wird neben dem Abtastphasengenerator 140 auch der Registriereinrichtung 142 zugeführt. Zwischen der Registriereinrichtung 142 und dem Abtastphasengenerator 140 werden während der Erzeugung der Abtastphase APH Statusmeldungen SM0, SM1 zyklisch ausgetauscht. Die Registriereinrichtung 142 erhält darüber hinaus noch eine von der Mikroprozessoranordnung 16 des Digitalteils 13 erzeugte Statusmeldung SM2 und eine von der Geräusch-Erkennungsschaltung 143 generierte Statusmeldung SM3. Aus den Statusmeldungen SM0, SM2, SM3 und dem Taktsignal TSI erzeugt die Registriereinrichtung die Statusmeldung SM1, die dem Abtastphasengenerator 140 zugeführt wird. Die Statusmeldungen SM0...SM3 sind dynamische, sich zeitlich ändernde Zustandsmeldungen der in der Steuereinrichtung 14 für die Erzeugung der Abtastphase angeordneten Baugruppen 140, 142, 143. Es sei an dieser Stelle erwähnt, daß die Steuereinrichtung 14 beispielsweise als integrierter ASIC-Baustein ausgebildet ist.

Mit dem letztmaligen Erhalt der Statusmeldung SM1 erzeugt der Abtastphasengenerator 140 aus dem digitalen Datenstrom DS und dem Taktsignal TSI die endgültige Abtastphase, die dann neben dem digitalen Datenstrom DS zur Synchronisation einer Synchronisationsanordnung 144 zugeführt wird. Die Synchronisationsanordnung 144 erzeugt dann aus dem digitalen Datenstrom DS und der Abtastphase APH einen synchronisierten digitalen Datenstrom S-DS, der dann in der Steuereinrichtung 14 des Schnurlos-Telekommunikationsgerätes 1 weiterverarbeitet wird. Die von dem Abtastphasengenerator 140 erzeugte Abtastphase APH wird jedoch nicht nur der Synchronisationsanordnung 144, sondern auch der Registriereinrichtung 142 zugeführt. Zusammen mit dem der Registriereinrichtung 142 ebenfalls zugeführten Datenstrom DS erzeugt die Registriereinrichtung 142 das Steuersignal STS, das sowohl der Schalteinrichtung 1210 als auch der Kompensationsschaltung 19 des Empfangsteiles 10 zugeführt wird. An den Signalflanken dieses Steuersignals STS wird zum einen die Schalteinrichtung 1210 und zum anderen die Kompensationsschaltung 19 gesteuert (siehe Beschreibung der Figur 8).

## Patentansprüche

1. Schnurlos-Telekommunikationsgerät, mit Konversionsmitteln (121) zur Umwandlung eines analogen HF-Signals (AS) in einen digitalen Datenstrom (DS) und mit Synchronisationsmitteln (14, 140, 144) zur Synchronisation des Datenstroms (DS) in bezug auf einen Gerätetakt,
**dadurch gekennzeichnet**, daß die Konversionsmittel (121) Komparatormittel (1211, 1212) umfassen, die das HF-Signal (AS) mit einem aus diesem durch Integration erzeugten Referenzsignal (RS) vergleichen und entsprechend dem Vergleichsergebnis den Datenstrom (DS) erzeugen und daß Erkennungsmittel (16, 142) vorgesehen sind, die im Fall des erstmaligen Aufeinanderfolgens zweier gleicher Bitwerte des synchronisierten Datenstroms (DS) die Komparatormittel (1211, 1212) derart steuern, daß die Integration des HF-Signals (AS) unterbrochen und die Integration der zu den beiden aufeinanderfolgenden Bitwerten korrespondierenden HF-Signalabschnitte kompensiert wird.

2. Schnurlos-Telekommunikationsgerät nach Anspruch 1,
**dadurch gekennzeichnet**, daß die Komparatormittel (1211, 1212) einen Analog/Digital-Komparator (1212) aufweisen, dem an einem ersten Eingang (El) und über eine Schalteinrichtung (1210), eine Kompensationsschaltung (19) sowie eine Integrationsschaltung (1211) an einem zweiten Eingang (E2) das HF-Signal (AS) zuführbar ist und der ausgangsseitig mit den Synchronisationsmitteln (14, 140, 144) verbunden ist.

3. Schnurlos-Telekommunikationsgerät nach Anspruch 2,
**dadurch gekennzeichnet**, daß die Integrationsschaltung (1211) als eine gegen Masse geschaltete RC-Parallelschaltung (R1, C1) ausgebildet ist.

4. Schnurlos-Telekommunikationsgerät nach Anspruch 2 oder 3, **dadurch gekennzeichnet**, daß die Schalteinrichtung (1210) und die Kompensationsschaltung (19) von den Erkennungsmitteln (16, 142) gesteuert sind.

5. Schnurlos-Telekommunikationsgerät nach Anspruch 4, **dadurch gekennzeichnet**, daß die Kompensationsschaltung (19) einen Kompensationskondensator (C_{KOMP}) aufweist.

6. Verwendung des Schnurlos-Telekommunikationsgerätes nach einem der Ansprüche 1 bis 5 als Basisstation in einem DECT-Kommunikationssystem.

7. Verwendung des Schnurlos-Telekommunikationsgerätes nach einem der Ansprüche 1 bis 5 als Mobilstation in einem DECT-Kommunikationssystem.

## Claims

1. Cordless telecommunication apparatus comprising conversion means (121) for converting an analog RF signal (AS) into a digital data stream (DS) and having synchronization means (14, 140, 144) for synchronizing the data stream (DS) with respect to an apparatus clock, characterized in that the conversion means (121) comprise comparator means (1211, 1212) which compare the RF signal (AS) with a reference signal (RS) generated from the former by means of integration and generate the data stream (DS) in accordance with the result of the comparison, and in that detection means (16, 142) are provided which, in the case of the first succession of two identical bit values of the synchronized data stream (DS), control the comparator means (1211, 1212) in such a manner that the integration of the RF signal (AS) is interrupted and the integration of the RF signal sections corresponding to the two successive bit values is compensated for.

2. Cordless telecommunication apparatus according to Claim 1, characterized in that the comparator means (1211, 1212) exhibit an analog/digital comparator (1212) which can be supplied with the RF signal (AS) at a first input (E1) and via a switching device (1210), a compensation circuit (19) and an integration circuit (1211) at a second input (E2), and the output of which is connected to the synchronization means (14, 140, 144).

3. Cordless telecommunication apparatus according to Claim 2, characterized in that the integration circuit (1211) is constructed as a parallel RC circuit (R1, C1) connected to earth.

4. Cordless telecommunication apparatus according to Claim 2 or 3, characterized in that the switching device (1210) and compensation circuit (19) are controlled by the detection means (16, 142).

5. Cordless telecommunication apparatus according to Claim 4, characterized in that the compensation circuit (19) exhibits a compensation capacitor (C_{COMP}).

6. Use of the cordless telecommunication apparatus according to one of Claims 1 to 5 as a base station in a DECT communication system.

7. Use of the cordless telecommunication apparatus according to one of Claims 1 to 5 as mobile station in a DECT communication system.

## Revendications

1. Appareil de télécommunication sans fil, comportant des moyens de conversion (121) pour la conversion d'un signal HF analogique (AS) en un flux de données (DS) numérique et des moyens de synchronisation (14, 140, 144) pour la synchronisation du flux de données (DS) sur une cadence d'appareil,
caractérisé par le fait que les moyens de conversion (121) comprennent des moyens de comparaison (1211, 1212), qui comparent le signal HF (AS) à un signal de référence (RS) produit à partir de ce signal HF par intégration et qui produisent en fonction du résultat de la comparaison le flux de données (DS), et que sont prévus des moyens de détection (16, 142) qui, à la première occurrence d'une succession de deux valeurs binaires identiques du flux de données (DS) synchronisé, commandent les moyens de comparaison (1211, 1212), de telle sorte que l'intégration du signal HF (AS) soit interrompue et que l'intégration des échantillons du signal HF qui correspondent aux deux valeurs binaires successives soit compensée.

2. Appareil de télécommunication sans fil selon la revendication 1, caractérisé par le fait que les moyens de comparaison (1211, 1212) comportent un comparateur analogique-numérique (1212) auquel peut être envoyé le signal HF (AS) à une première entrée (E1) et, par l'intermédiaire d'un dispositif interrupteur (1210), d'un circuit compensateur (19) et d'un circuit intégrateur (1211), à une seconde entrée (E2) et qui est relié en sortie aux moyens de synchronisation (14, 140, 144).

3. Appareil de télécommunication sans fil selon la revendication 2, caractérisé par le fait que le circuit intégrateur (1211) est construit comme un circuit parallèle RC (R1, C1) branché à la masse.

4. Appareil de télécommunication sans fil selon la revendication 2 ou 3, caractérisé par le fait que le circuit interrupteur (1210) et le circuit compensateur (19) sont commandés par les moyens de détection (16, 142).

5. Appareil de télécommunication sans fil selon la revendication 4, caractérisé par le fait que le circuit compensateur (19) comporte un condensateur compensateur (C_{KOMP}).

6. Utilisation de l'appareil de télécommunication sans fil selon l'une des revendications 1 à 5, comme station de base dans un système de communication DECT.

7. Utilisation de l'appareil de télécommunication sans fil selon l'une des revendications 1 à 5 comme station mobile dans un système de communication DECT.
